# EUROPEAN PATENT APPLICATION

(11) **EP 4 664 505 A1**
(43) Date of publication of application: **17.12.2025**
(21) Application number: 25182838.0
(22) Date of filing: 13.06.2025
(51) Int. Cl.: H01H 36/00, H01H 3/16

(54) **DIRECTED ACTIVATION REED SENSOR**

(30) Priority: 14.06.2024 CN 202410774488
(71) Applicant: Dongguan Littelfuse Electronics Company Limited, Dongguan, Guangdong 523925 (CN)
(72) Inventor: Xiao, Jowell, Dongguan City, 523925 (CN); Huang, Tracy Jia, Dongguan City, 523925 (CN); Zhang, Free, Dongguan City, 523925 (CN)
(74) Representative: Arnold & Siedsma

(57) **Abstract**

A reed sensor including a dielectric substrate, a reed switch mounted to a first side of the dielectric substrate, and a ferromagnetic shield disposed on the first side of the dielectric substrate, wherein the ferromagnetic shield covers the reed switch.

## Description

### BACKGROUND

### Field

The present disclosure relates generally to the field of sensors. More specifically, the present disclosure relates to a reed sensor that is resistant to magnetic interference.

### Description of Related Art

A reed sensor is an electromechanical device used to detect the presence or absence of a magnetic field. A typical reed sensor includes a reed switch formed of two thin, ferromagnetic, flexible metal reeds disposed in an insulating housing with a gap between end portions of the reeds. When the reed sensor is placed in proximity to a magnet, a magnetic field is induced in the reeds of the reed switch, causing the reeds to deflect into contact with one another. The reed switch is thereby closed, allowing electrical current to flow therethrough. The electrical current is typically interpreted as a signal indicating the presence of a magnetic field in proximity to the reed sensor. Reed sensors are commonly used for proximity sensing and position sensing.

Reed sensors are widely used because of their low cost, simplicity, and reliability. However, one shortcoming associated with reed sensors is their susceptibility to outside magnetic forces. That is, magnetic forces generated by sources other than a target magnet can interfere with proper operation of the reed switch, such as by causing the reed switch to close even when the reed switch is not in proximity to the target magnet, or by preventing the reed switch from closing when the reed switch is in proximity to the target magnet. It is with respect to these and other considerations that the present improvements may be useful.

### Summary

This Summary is provided to introduce a selection of concepts in a simplified form further described below in the Detailed Description. This Summary is not intended to identify key features or essential features of the claimed subject matter, nor is the summary intended as an aid in determining the scope of the claimed subject matter.

A reed sensor in accordance with the present disclosure may include a dielectric substrate, a reed switch mounted to a first side of the dielectric substrate, and a ferromagnetic shield disposed on the first side of the dielectric substrate, wherein the ferromagnetic shield covers the reed switch.

A sensor assembly in accordance with the present disclosure may include a permanent magnet assembly including a magnet disposed within a housing, and a reed sensor disposed adjacent the permanent magnet assembly for detecting proximity of the magnet, the reed sensor including a dielectric substrate, a reed switch mounted to a first side of the dielectric substrate, and a ferromagnetic shield disposed on the first side of the dielectric substrate, wherein the ferromagnetic shield covers the reed switch.

### BRIEF DESCRIPTION OF THE DRAWINGS

By way of example, various embodiments of the present disclosure will now be described, with reference to the accompanying drawings, wherein:
**FIG. 1A** is a perspective view illustrating a reed sensor in accordance with the present disclosure;
**FIG. 1B** is an exploded view illustrating the reed sensor of **FIG. 1A****;**
**FIG. 1C** is a partially exploded view illustrating the reed sensor of **FIG. 1A****;**
**FIG. 2A** is a cross-sectional view illustrating an embodiment of a reed switch of the reed sensor of **FIG. 1A** in an open state;
**FIG. 2B** is a cross-sectional view illustrating the reed switch of **FIG. 2A** in a closed state;
**FIG. 3** is a cross-sectional view illustrating the reed sensor of **FIG. 1A** adjacent a permanent magnet assembly.

### DETAILED DESCRIPTION

As used herein, an element or operation recited in the singular and proceeded with the word "a" or "an" are understood as possibly including plural elements or operations, except as otherwise indicated. Furthermore, various embodiments herein have been described in the context of one or more elements or components. An element or component may comprise any structure arranged to perform certain operations.

A reed sensor in accordance with the present disclosure will now be described more fully with reference to the accompanying drawings.. In the drawings, like numbers refer to like elements throughout unless otherwise noted.

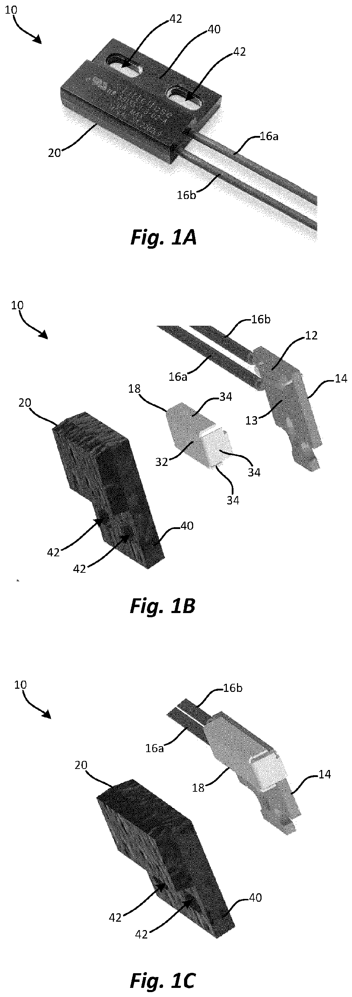

Referring to **FIGS. 1A-1C****,** several views illustrating a reed sensor 10 in accordance with the present disclosure are shown. The reed sensor 10 may generally include a reed switch 12 (*see* **FIG. 1B**) mounted to a first side 13 of a dielectric substrate 14, first and second conductors 16a, 16b electrically connected to the reed switch 12 (as further described below), a ferromagnetic shield 18 covering at least a portion of the first side 13 of the dielectric substrate 14, including the reed switch 12 (as shown in **FIG. 1C**), and a dielectric housing 20 within which the reed switch 12, the dielectric substrate 14, and the ferromagnetic shield 18 are contained.

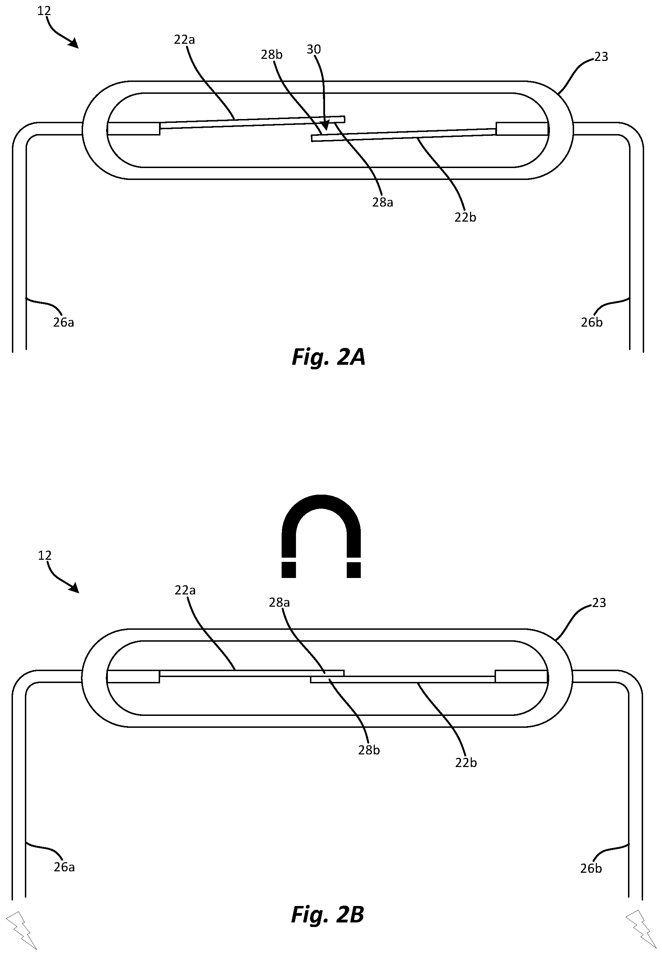

Referring to **FIG. 2A****,** a detail view illustrating the reed switch 12 of the reed sensor 10 is shown. The reed switch 12 may be of any conventional variety know to those of ordinary skill in the art. For example, the reed switch 12 may include a dielectric capsule 20 (e.g., a generally cylindrical glass capsule). First and second reed blades 22a, 22b may be disposed within a hermetically sealed volume within the dielectric capsule 23 and may be connected to respective first and second leads 26a, 26b that extend through opposing axial ends of the dielectric capsule 20. In various embodiments, the ends of the dielectric capsule 23 may be heated and fused to the first and second leads 26a, 26b, thus positioning the connected first and second reed blades 22a, 22b with respect to each other within the dielectric capsule 23 and forming a hermetic seal to enclose the capsule volume. The capsule volume may contain either a vacuum or an inert gas such as nitrogen or argon, sometimes at above atmospheric pressures.

Although non-limiting, a portion of each of the first and second reed blades 22a, 22b may be flattened, producing a controlled spring constant which controls the force required to close the reed switch 12. The first and second reed blades 22a, 22b may terminate in respective first and second contact portions 28a, 28b. The first and second contacts portions 28a, 28b of the first and second reed blades 22a, 22b overlap, defining a contact space or gap 30 therebetween.

The first and second reed blades 22a, 22b may be formed of a ferromagnetic alloy, typically an alloy of nickel and iron having a composition of, for example, 51-52 percent nickel. In the presence of a magnetic field, such as may be generated by an adjacent magnet (not shown), the magnetic field may permeate the first and second reed blades 22a, 22b, causing the first and second reed blades 22a, 22b to attract one another. The attraction force causes flexure of the first and second reed blades 22a, 22b so that the contact portions 28 move into engagement with one another and complete an electrical circuit between the first and second leads 26a, 26b as shown in **FIG. 2B****.** When the magnetic field is removed, a magnetic field no longer permeates the first and second reed blades 22a, 22b and the contacts portions 28 separate, reestablishing the contact gap 34 and breaking the electrical circuit between the first and second leads 26a, 26b.

When the reed switch 12 is mounted on the dielectric substrate 14 (as shown in **FIG. 1B**), the first and second leads 26a, 26b may be electrically connected to the first and second conductors 16a, 16b, respectively. When the reed sensor 10 is connected within a circuit, the first conductor 16a may be connected to a source of electrical power, and the second conductor 16b may be connected to a controller or other device/circuit adapted to determine whether the reed switch 12 is open or closed based on the presence or absence of electrical current in the second conductor 16b. The present disclosure is not limited in this regard.

Referring again to **FIGS. 1B** and **1C****,** the ferromagnetic shield 18 may be a generally box-shaped member having a front wall 32 and a plurality of adjoining sidewalls 34 extending perpendicularly from the front wall 32 (e.g., four adjoining sidewalls 34, one of which is not within view in **FIGS. 1B** and **1C**)**.** In various embodiments, the ferromagnetic shield 18 may be formed of a sheet of metal that is cut and bent (or otherwise shaped) to form a box shape with an open side as depicted. The present disclosure is not limited in this regard. The ferromagnetic shield 18 may be disposed on the first side 13 of the dielectric substrate 14 and may cover the reed switch 12. The ferromagnetic shield 18 may be formed of any ferromagnetic material, including, but not limited to, iron, nickel, cobalt, etc. During operation of the reed sensor 10, the ferromagnetic shield 18 may act as a barrier that absorbs and redirects magnetic fields and thus prevents the reed switch 12 from being influenced by such magnetic fields as further described below.

The dielectric housing 20 may be formed of any suitable dielectric material, including, but not limited to, various thermoplastics, epoxies, etc. In various embodiments, the dielectric housing 20 may be overmolded directly onto the reed switch 12, the dielectric substrate 14, the ferromagnetic shield 18, and the adjacent portions of the first and second conductors 16a, 16b. The present disclosure is not limited in this regard. The dielectric housing 20 may include a mounting flange 40 having apertures 42 formed therein for accepting mechanical fasteners (e.g., screws) to facilitate attachment of the reed sensor 10 to a surface.

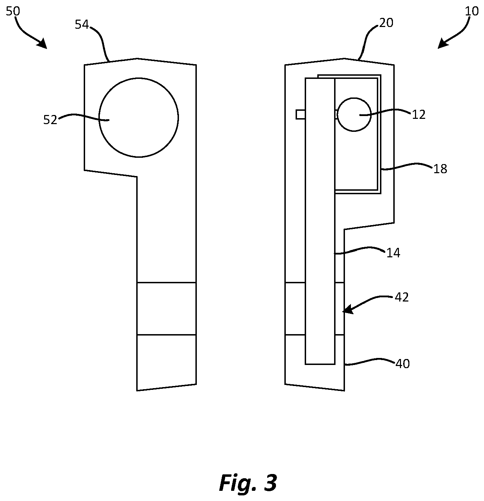

Referring to **FIG. 3****,** a cross-sectional view illustrating the reed sensor 10 of the present disclosure disposed adjacent a permanent magnet assembly 50 is shown. Together, the reed sensor 10 and the permanent magnet assembly 50 may be referred to as "a sensor assembly." The permanent magnet assembly 50 may generally include a magnet 52 disposed within a housing 54. When the reed sensor 10 is moved into and out of proximity with the permanent magnet assembly 50, the magnet 52 may cause the reed switch 12 to close and open as described above. As shown in **FIG. 3****,** the ferromagnetic shield 18 may be disposed on an opposite side of the reed switch 12 relative to the permanent magnet assembly 50. The ferromagnetic shield 18 may be said to cover a "first side" of the reed switch 12, while a "second side" of the reed switch 12 (e.g., the side on which the permanent magnet assembly 50 is located when the reed sensor 10 is moved into proximity with the permanent magnet assembly 50 during operation) is not covered by the ferromagnetic shield 18. Thus, during operation of the reed sensor 10, the ferromagnetic shield 18 may prevent the reed switch 12 from being influenced by "outside" magnetic fields (i.e., magnetic fields emanated from sources other than the magnet 52) on the first side of the reed switch 12, while allowing the reed switch 12 to be influenced by a magnetic field emanating from the magnet 52 on the second side of the reed switch. Proper operation of the reed sensor 10 is thereby maintained even in the presence of outside magnetic forces.

As used herein, an element or step recited in the singular and proceeded with the word "a" or "an" should be understood as not excluding plural elements or steps, unless such exclusion is explicitly recited.

## Claims

1. A reed sensor comprising:
a dielectric substrate;
a reed switch mounted to a first side of the dielectric substrate; and
a ferromagnetic shield disposed on the first side of the dielectric substrate, wherein the ferromagnetic shield covers the reed switch.

2. The reed sensor of claim 1, further comprising a dielectric housing encasing the dielectric substrate, the reed switch, and the ferromagnetic shield.

3. The reed sensor of claim 2, further comprising first and second conductors connected the reed switch and extending outside of the dielectric housing.

4. The reed sensor of any of the claims 1-3. wherein the reed switch comprises:
a dielectric capsule; and
ferromagnetic first and second reed blades disposed within a hermetically sealed volume within the dielectric capsule and connected to respective first and second leads extending through opposing axial ends of the dielectric capsule, wherein the first and second reed blades terminate in respective first and second contact portions that overlap and define a contact gap therebetween.

5. The reed sensor of any of the preceding claims, wherein the ferromagnetic shield includes a front wall and a plurality of adjoining sidewalls extending perpendicularly from the front wall.

6. The reed sensor of any of the preceding claims, wherein the ferromagnetic shield is formed of one of nickel, iron, and cobalt.

7. The reed sensor of any of the preceding claims, wherein the ferromagnetic shield covers a first side of the reed switch but does not cover a second side of the reed switch opposite the first side.

8. A sensor assembly comprising:
a permanent magnet assembly comprising a magnet disposed within a housing;
and
a reed sensor disposed adjacent the permanent magnet assembly for detecting proximity of the magnet, the reed sensor comprising:
a dielectric substrate;
a reed switch mounted to a first side of the dielectric substrate; and
a ferromagnetic shield disposed on the first side of the dielectric substrate, wherein the ferromagnetic shield covers the reed switch.

9. The sensor assembly of claim 8, further comprising a dielectric housing encasing the dielectric substrate, the reed switch, and the ferromagnetic shield.

10. The sensor assembly of claim 9, further comprising first and second conductors connected the reed switch and extending outside of the housing.

11. The sensor assembly of any of the claims 8-10, wherein the reed switch comprises:
a dielectric capsule; and
ferromagnetic first and second reed blades disposed within a hermetically sealed volume within the dielectric capsule and connected to respective first and second leads extending through opposing axial ends of the dielectric capsule, wherein the first and second reed blades terminate in respective first and second contact portions that overlap and define a contact gap therebetween.

12. The sensor assembly of any of the claims 8-11, wherein the ferromagnetic shield includes a front wall and a plurality of adjoining sidewalls extending perpendicularly from the front wall.

13. The sensor assembly of any of the claims 8-12, wherein the ferromagnetic shield is formed of one of nickel, iron, and cobalt.

14. The sensor assembly of any of the claims 8-13, wherein the ferromagnetic shield covers a first side of the reed switch but does not cover a second side of the reed switch opposite the first side, and/or wherein during operation of the sensor assembly, the reed switch is allowed to be influenced by a magnetic field emanated by the magnet but is shielded from other magnetic fields by ferromagnetic shield.

15. Use of a reed sensor according to any of the claims 1-7, or a sensor assembly according to any of the claims 8-14 for detecting the presence or absence of a magnetic field.
